# EUROPÄISCHE PATENTSCHRIFT

(11) **EP 3 290 888 B1**
(45) Veröffentlichungstag und Bekanntmachung des Hinweises auf die Patenterteilung: **22.07.2020**
(21) Anmeldenummer: 16187036.5
(22) Anmeldetag: 02.09.2016
(51) Int. Cl.: G01L 19/06, G01L 23/10, H01L 41/053

(54) **DRUCKSENSOR FÜR HOHE BETRIEBSTEMPERATUREN**
PRESSURE SENSOR FOR HIGH OPERATING TEMPERATURES
CAPTEUR DE PRESSION POUR TEMPERATURES DE FONCTIONNEMENT ELEVEES

(43) Veröffentlichungstag der Anmeldung: 07.03.2018
(73) Patentinhaber: Kistler Holding AG, 8408 Winterthur (CH)
(72) Erfinder: Heer, Christian, 8400 Winterthur (CH)

(56) Entgegenhaltungen:
- WO-A1-2013/147260
- CH-A- 386 729
- US-B1- 6 998 761

## Beschreibung

### Technisches Gebiet

Die Erfindung betrifft einen Drucksensor nach dem Oberbegriff des unabhängigen Anspruches sowie die Verwendung eines Drucksensors zum Erfassen von Drücken bei hohen Temperaturen über 300°C oder bis 1000°C.

### Stand der Technik

Drucksensoren sind bekannt und werden vielfältig eingesetzt. Insbesondere mit piezoelektrischen Drucksensoren lassen sich hohe Drücke über 50bar erfassen. Piezoelektrische Drucksensoren können schnelle Druckverläufe erfassen, mit Messfrequenzen, die eine zeitliche Auflösung von bis zu 100kHz haben. Dabei liegt die Temperatur die ein handelsüblicher piezoelektrischer Drucksensor im Betrieb dauerhaft erträgt, unterhalb von 300°C.

Ein solcher piezoelektrischer Drucksensor ist beispielsweise in der Schrift CH386729A offenbart. Der zu erfassende Druck wirkt über eine Membran als Normalkraft auf stirnseitige Aussenflächen eines Piezoelementes und erzeugt auf den Aussenflächen elektrische Ladungen. Die elektrischen Ladungen werden von auf den Aussenflächen angeordneten Elektroden abgegriffen. Das Piezoelement und die Elektroden sind in einer rohrförmigen Vorspannhülse angeordnet. Die Vorspannhülse spannt die Elektroden mechanisch gegen das Piezoelement vor.

Eine Anzahl der erzeugten elektrischen Ladungen ist proportional zur Grösse der Normalkraft. Die Anzahl der erzeugten elektrischen Ladungen ist das Ausgangssignal des piezoelektrischen Druckaufnehmers. Die mechanische Vorspannung vermeidet nichtkontaktierte Bereiche mit lokalen hohen elektrischen Spannungen und elektrischen Kriechströmen zwischen den Elektroden und dem Piezoelement, und führt zu einer sehr guten Linearität des piezoelektrischen Drucksensors. Die Linearität ist die Abweichung der Proportionalität zwischen dem Ausgangssignal und dem zu erfassenden Druck.

Ein Verhältnis des Ausgangssignals zu einer Änderung des Druckes wird als Empfindlichkeit des piezoelektrischen Drucksensors bezeichnet. Wünschenswert ist ein piezoelektrischer Drucksensor mit möglichst hoher Empfindlichkeit. Dies lässt sich dadurch bewerkstelligen, dass die Normalkraft in einem grösseren Kraftnebenschluss auf das Piezoelement und in einem kleineren Kraftnebenschluss auf die Vorspannhülse wirkt. Mit dem grösseren Kraftnebenschluss wird ein vergleichsweise grösserer prozentualer Anteil der Normalkraft bezeichnet. Mit dem kleineren Kraftnebenschluss wird ein vergleichsweise kleinerer prozentualer Anteil der Normalkraft bezeichnet. Der grössere prozentuale Anteil der Normalkraft ist um ein Mehrfaches grösser als der kleinere prozentuale Anteil der Normalkraft. Ein möglichst kleiner Kraftnebenschluss der Vorspannhülse wird üblicherweise mit einer rohrförmigen Vorspannhülse erreicht, welche durch spanendes Bearbeiten dünnwandig gestaltet ist.

Zur Verbesserung der elektrischen Isolation des Piezoelementes wird in der Schrift CH386729A ein elektrisch isolierendes Polymer, vorzugsweise Silikonöl, vorgeschlagen. Zusätzlich weist die Vorspannhülse Durchbrechungen, wie beispielsweise Schlitze, auf, durch die das Silikonöl fliessen kann und so als Kühlflüssigkeit für den Drucksensor dient.

WO2013147260A1 offenbart einen Drucksensor für den Einsatz in einer Brennkammer mit einem Gehäuse und einer Membran, wobei im Gehäuse ein piezoelektrisches Element von einer Vorspannhülse vorgespannt ist. Die Vorspannhülse ist mit Öffnungen versehen, wodurch eine Federstruktur erzeugt wird. Da der Drucksensor im Betrieb hohen Temperaturen bis 350°C gefertigt.

Für einen Betrieb bei hohen Temperaturen von über 300°C, wie beispielsweise bei der Drucküberwachung in Objekten wie Strahltriebwerken, Gasturbinen, Dampfturbinen, Verbrennungsmaschinen usw. eignet sich der in der Schrift CH386729A offenbarte piezoelektrische Drucksensor hingegen nicht. Die Verwendung einer im Drucksensor fliessenden Kühlflüssigkeit ist konstruktiv aufwändig und sowohl in der Herstellung als auch im Betrieb teuer. Piezoelektrische Drucksensoren haben Lebensdauern von 10.000 bis zu 25.000 Betriebsstunden. Die piezoelektrischen Drucksensoren müssen im Betrieb während ihrer gesamten Lebensdauer die Spezifikationen von Empfindlichkeit und Linearität erfüllen.

### Darstellung der Erfindung

Eine erste Aufgabe der Erfindung ist es daher, die Nachteile des Stands der Technik zumindest teilweise zu überwinden. Insbesondere ist ein Drucksensor wünschenswert, der bei hohen Temperaturen über 300°C oder bis 1000°C betrieben werden kann. Eine weitere Aufgabe der Erfindung besteht darin, einen Drucksensor aufzuzeigen, der auch bei hohen Temperaturen schnelle Druckverläufe erfassen kann. Der Drucksensor soll eine sehr gute Linearität und eine hohe Empfindlichkeit aufweisen. Auch soll der Drucksensor in der Herstellung und im Betrieb kostengünstig sein.

Die Lösung der Aufgabe ist durch die Merkmale des unabhängigen Anspruches definiert. Der erfindungsgemässe Drucksensor, der für den Betrieb bei hohen Temperaturen über 300°C oder bis 1000°C geeignet ist, weist eine Vorspannhülse und einen piezoelektrischen Druckaufnehmer auf, wobei der piezoelektrische Druckaufnehmer in der Vorspannhülse angeordnet ist und wobei die Vorspannhülse den piezoelektrischen Druckaufnehmer mechanisch vorspannt. Die Vorspannhülse besteht aus einem zeitstandfestem Werkstoff. Die Vorspannhülse weist mindestens ein steifigkeitsminderndes Element auf.

Bei Temperaturen über 300°C oder bis 1000°C sind alle Gefügevorgänge in einem Werkstoff thermisch aktiviert, was über die Zeit gesehen und unter mechanischer Last zu Werkstoffschädigung wie eine plastische Verformung (Kriechen) führt. Nach der Lehre der Schrift CH386729A wird der Drucksensor im Betrieb daher gekühlt. In Abkehr von dieser Lehre besteht die erfindungsgemässe Vorspannhülse aus einem zeitstandfesten Werkstoff. Der Drucksensor muss somit im Betrieb nicht gekühlt werden. Unter Zeitstandfestigkeit wird eine Bruchbeständigkeit des Werkstoffes bei hohen Temperaturen über 300°C oder bis 1000°C und bei hohen Drücken über 50bar verstanden, derart, dass eine Lebensdauer des Drucksensors von 10.000 bis zu 25.000 Betriebsstunden beträgt.

Der piezoelektrische Druckaufnehmer ist in der Vorspannhülse mechanisch vorgespannt. Eine Normalkraft wirkt entlang einer Längsachse der Vorspannhülse im grösseren Kraftnebenschluss auf den piezoelektrischen Druckaufnehmer und im kleineren Kraftnebenschluss auf die Vorspannhülse. Für einen möglichst kleinen Kraftnebenschluss ist die Vorspannhülse üblicherweise durch spanendes Bearbeiten dünnwandig gestaltet. Nun lassen sich zeitstandfeste Werkstoffe nur mit grossem materiellen- und Kostenaufwand spanend bearbeiten. Eine Verwendung von zeitstandfestem Werkstoff für eine Vorspannhülse ist deshalb bisher verworfen worden.

Es ist dennoch erkannt worden, dass sich eine Vorspannhülse aus zeitstandfestem Werkstoff mit möglichst kleinem Kraftnebenschluss rasch und einfach herstellen lässt, wenn nicht versucht wird, die Vorspannhülse dünnwandig zu gestalten. Erfindungsgemäss weist die Vorspannhülse mindestens ein steifigkeitsminderndes Element auf, welches eine längsaxiale Steifigkeit der Vorspannhülse vermindert. Die Vorspannhülse kann einen rohrförmigen Abschnitt aufweisen. Das steifigkeitsmindernde Element kann insbesondere eine Wandöffnung im rohrförmigen Abschnitt sein. Durch Form und Anzahl der steifigkeitsmindernden Elemente lässt sich die längsaxiale Steifigkeit der Vorspannhülse gezielt minimieren.

In bevorzugten Ausführungsformen ist das steifigkeitsmindernde Element eine kreisförmige oder ovale oder mehreckige Wandöffnung im rohrförmigen Abschnitt. Bei mehreren steifigkeitsmindernden Elementen sind insbesondere alle steifigkeitsmindernden Elemente als kreisförmige oder ovale oder mehreckige Wandöffnungen im rohrförmigen Abschnitt ausgebildet. Die Wandöffnung im rohrförmigen Abschnitt kann eine Bohrung sein.

In einer weiteren bevorzugten Ausführungsform sind mehrere der steifigkeitsmindernden Elemente in einer Reihe entlang einer geraden Linie, die parallel zur axialen Richtung der Vorspannhülse verläuft, angeordnet. In längsaxialer Richtung der Vorspannhülse kann eine Vielzahl von steifigkeitsmindernden Elementen hintereinander, beispielsweise in Form einer Reihe von steifigkeitsmindernden Elementen entlang einer geraden Linie angeordnet sein. Die Reihe von steifigkeitsmindernden Elementen entlang der geraden Linie kann parallel zur Längsachse der Vorspannhülse angeordnet sein. Die Anzahl der steifigkeitsmindernden Elemente einer Reihe von steifigkeitsmindernden Elementen kann im Bereich von zwei bis zwanzig, insbesondere im Bereich von drei bis vierzehn, im Speziellen im Bereich von fünf bis neun, und im ganz Speziellen bei sieben liegen. Die Anzahl der steifigkeitsmindernden Elemente einer Reihe von steifigkeitsmindernden Elementen kann einer geraden oder einer ungeraden Zahl entsprechen. Die Abstände zwischen benachbarten steifigkeitsmindernden Elementen einer Reihe von steifigkeitsmindernden Elementen können im Wesentlichen gleich sein. Die Grösse verschiedener steifigkeitsmindernder Elemente einer Reihe von steifigkeitsmindernden Elementen kann im Wesentlichen gleich sein. Unter der Grösse eines steifigkeitsmindernden Elementes ist die Oberfläche des steifigkeitsmindernden Elementes zu verstehen. Falls steifigkeitsvermindernde Elemente in Form von Wandöffnungen im rohrförmigen Abschnitt der Vorspannhülse verwendet werden, können die Durchmesser verschiedener Wandöffnungen im rohrförmigen Abschnitt im Wesentlichen gleich sein. Die Durchmesser der Wandöffnungen einer Reihe von Wandöffnungen können grösser sein als die Abstände zwischen zwei benachbarten Wandöffnungen einer Reihe von Wandöffnungen.

In noch einer weiteren bevorzugten Ausführungsform sind mehrere der steifigkeitsmindernden Elemente in mehreren Reihen entlang gerader Linien, die parallel zur axialen Richtung der Vorspannhülse verlaufen, angeordnet. Die Anzahl der Reihen von steifigkeitsmindernden Elementen, die über den Umfang der Vorspannhülse verteilt sind, kann im Bereich von zwei bis zwanzig, insbesondere im Bereich von vier bis zehn, und im Speziellen bei sechs liegen. Die Anzahl der Reihen von steifigkeitsmindernden Elementen, die über den Umfang der Vorspannhülse verteilt sind, kann gerade oder ungerade sein. Die mehreren Reihen von steifigkeitsmindernden Elementen können jeweils die gleiche Anzahl von steifigkeitsmindernden Elementen haben, und/oder sie können, zumindest teilweise, verschiedene Anzahlen von steifigkeitsmindernden Elementen haben. Die mehreren Reihen von steifigkeitsmindernden Elementen können parallel zueinander und parallel zur Längsachse der Vorspannhülse verlaufen.

In dazu noch einer weiteren bevorzugten Ausführungsform sind die Reihen von steifigkeitsmindernden Elementen versetzt angeordnet. Die Anordnung von zwei parallelen Reihen von steifigkeitsmindernden Elementen kann versetzt zueinander sein. Die Versetzung kann beispielsweise 0.25 bis 0.75-mal der Distanz zwischen zwei Mittelpunkten von zwei benachbarten steifigkeitsmindernden Elementen einer Reihe von steifigkeitsmindernden Elementen entsprechen. Insbesondere entspricht die Versetzung der halben Distanz zwischen zwei Mittelpunkten von zwei benachbarten steifigkeitsmindernden Elementen einer Reihe von steifigkeitsmindernden Elementen. Der Abstand zwischen zwei benachbarten steifigkeitsmindernden Elementen einer Reihe von steifigkeitsmindernden Elementen kann im Wesentlichen gleich sein dem Abstand zwischen zwei steifigkeitsmindernden Elementen von zwei benachbarten Reihen von steifigkeitsmindernden Elementen. Die Vorspannhülse kann eine Vielzahl von Wandöffnungen im rohrförmigen Abschnitt haben, die in mehreren parallelen, versetzten Reihen über den Umfang der Vorspannhülse angeordnet sind.

Ein prozentualer Anteil einer Oberfläche aller steifigkeitsmindernden Elemente im rohrförmigen Abschnitt der Vorspannhülse an einer Gesamtoberfläche des rohrförmigen Abschnittes der Vorspannhülse stellt einen Öffnungsgrad der Vorspannhülse dar. Die Gesamtoberfläche des rohrförmigen Abschnittes der Vorspannhülse entspricht einer Oberfläche des rohrförmigen Abschnittes einer Vorspannhülse, die keine steifigkeitsmindernden Elemente aufweist. Je grösser der Öffnungsgrad ist, desto offener ist die Vorspannhülse. In einer besonders bevorzugten Ausführungsform kann der Öffnungsgrad der Vorspannhülse im Bereich von 30% bis 90%, insbesondere im Bereich von 40% bis 80%, im Speziellen im Bereich von 50% bis 70%, und im ganz Speziellen bei weitgehend 65% liegen. Das Adjektiv "weitgehend" kennzeichnet ein bestimmtes Merkmal (in diesem Fall den Öffnungsgrad) mit einer Genauigkeit von +/-10%.

In noch einer weiteren bevorzugten Ausführungsform beträgt eine Gesamtlänge in längsaxialer Richtung der Vorspannhülse mindestens das Fünffache, insbesondere mindestens das Zehnfache eines Gesamtdurchmessers in radialer Richtung der Vorspannhülse. Es hat sich gezeigt, dass das steifigkeitsmindernde Element so gestaltet sein kann, dass es längsaxiale Eigenfrequenzen des Drucksensors nicht beeinflusst. Eigenfrequenzen des Drucksensors sind freie (nicht erzwungene) Schwingung des Drucksensors. Für eine möglichst grosse zeitliche Auflösung des Drucksensors sollten die Eigenfrequenzen hoch sein, denn sobald die Messfrequenz grösser als 10% einer Eigenfrequenz ist, kann das Erfassen der schnellen Druckverläufe gestört werden. Eigenfrequenzen des Drucksensors sind durch die geometrische Abmessung und die Formgebung des Drucksensors und seiner Bestandteile gegeben. Eigenfrequenzen des Drucksensors in längsaxialer Richtung überlagern sich mit der auf das Piezoelement wirkenden Normalkraft und sind deshalb besonders störend. Mittels der Anzahl, der Form, der Grösse und der Anordnung der Wandöffnungen im rohrförmigen Abschnitt der Vorspannhülse lassen sich Eigenfrequenzen des Drucksensors in längsaxialer Richtung und in radialer Richtung gezielt einstellen. In einer bevorzugten Ausführungsform weist die Wandöffnung einen grössten Durchmesser auf und der grösste Durchmesser der Wandöffnung ist so bemessen, dass eine grösste Länge des rohrförmigen Abschnittes der Vorspannhülse ein Vielfaches, insbesondere ein Drei- bis Zwanzigfaches des grössten Durchmessers der Wandöffnung beträgt.

Es hat sich ferner gezeigt, dass die Eigenfrequenzen des Drucksensors so eingestellt werden können, dass die Eigenfrequenz des Drucksensors in längsaxialer Richtung weitgehend das Zehnfache der Eigenfrequenz des Drucksensors in radialer Richtung beträgt. Besonders vorteilhaft haben sich dabei Eigenfrequenzen des Drucksensors in längsaxialer Richtung im Bereich vom 10kHz bis 100kHz, insbesondere im Bereich von 20kHz bis 80kHz, im Speziellen im Bereich von 40kHz bis 60kHz, und im ganz Speziellen von im Wesentlichen 50kHz erwiesen. Ebenso vorteilhaft haben sich Eigenfrequenzen des Drucksensors in radialer Richtung im Bereich vom 1kHz bis 10kHz, insbesondere im Bereich von 2kHz bis 8kHz, im Speziellen im Bereich von 4kHz bis 6kHz, und im ganz Speziellen von im Wesentlichen 5kHz erwiesen. Diese Eigenfrequenzen des Drucksensors erlauben eine hohe zeitliche Auflösung des Drucksensors von bis zu 100kHz auch bei hohen Temperaturen.

Eine Wandstärke der Vorspannhülse entspricht insbesondere der Wandstärke im rohrförmigen Abschnitt der Vorspannhülse. Für einen möglichst kleinen Kraftnebenschluss ist die Vorspannhülse mit einer minimalen Wandstärke ausgeführt. Die Wandstärke entspricht in diesem Fall dem Aussenradius der Vorspannhülse im rohrförmigen Abschnitt abzüglich des Innenradius der Vorspannhülse im rohrförmigen Abschnitt.

Es hat sich herausgestellt, dass eine Wandstärke der Vorspannhülse in einem Verhältnis zu einer Korngrösse des Werkstoffes der Vorspannhülse steht. Unter einer Korngrösse ist der mittlere Korndurchmesser des Werkstoffes der Vorspannhülse zu verstehen. Dieser mittlere Korndurchmesser wird nach Standard E112 - 10 der ASTM Int'l (Standard Test Methods for Determining Average Grain Size) ermittelt. Eine solche Vorspannhülse ist spanabhebend und somit wirtschaftlich herstellbar. Die Wandstärke der Vorspannhülse beträgt das Drei- bis Zwanzigfache, und im Speziellen das Vier- bis Zehnfache der Korngrösse des Werkstoffes der Vorspannhülse.

In einer weiteren bevorzugten Ausführungsform beträgt die Wandstärke der Vorspannhülse mindestens das Fünffache der Korngrösse des Werkstoffes der Vorspannhülse und ist dann zeitstandfest.

In noch einer weiteren bevorzugten Ausführungsform beträgt die Wandstärke der Vorspannhülse mindestens das Fünffache der Korngrösse des Werkstoffes der Vorspannhülse und der prozentuale Anteil der Normalkraft, welcher auf die Vorspannhülse wirkt (der kleinere Kraftnebenschluss) ist umgekehrt proportional zum Öffnungsgrad der Vorspannhülse. So kann bei einer solchen Wandstärke für einen Öffnungsgrad der Vorspannhülse von 0% (der rohrförmige Abschnitt der Vorspannhülse weist keine steifigkeitsmindernden Elemente auf) der kleinere Kraftnebenschluss 45% betragen. Bei der gleichen Wandstärke kann der kleinere Kraftnebenschluss für einen Öffnungsgrad der Vorspannhülse von weitgehend 65% dann 25% betragen.

In noch einer bevorzugten Ausführungsform liegt die Korngrösse des Werkstoffes der Vorspannhülse in einem Bereich von 10pm bis 100µm und insbesondere in einem Bereich von 30pm bis 70pm liegen. Im Speziellen kann die Korngrösse der des Werkstoffes der Vorspannhülse weitgehend 50pm oder im Wesentlichen 50pm betragen. Die Wandstärke der Vorspannhülse im rohrförmigen Abschnitt kann in einem Bereich von 50pm bis 1mm und insbesondere in einem Bereich von 150µm bis 0.5mm liegen. Im Speziellen kann die Wandstärke der Vorspannhülse im rohrförmigen Abschnitt weitgehend 0.25mm oder im Wesentlichen 0.25mm betragen.

Der zeitstandfesten Werkstoff der Vorspannhülse besteht aus einer Legierung, welche Nickel als Hauptbestandteil enthält. Der Hauptbestandteil einer Legierung ist der Bestandteil mit dem grössten prozentualen Anteil aller in der Legierung vorkommenden Bestandteile. Unter dem prozentualen Anteil ist hier und im Folgenden immer der prozentuale Gewichtsanteil zu verstehen.

In einer weiteren bevorzugten Ausführungsform enthält die Legierung des zeitstandfesten Werkstoffes der Vorspannhülse zusätzlich Chrom und/oder Kobalt. Dabei kann die Legierung prozentuale Anteile von Chrom im Bereich von 5% bis 33% und/oder von Kobalt im Bereich von 5% bis 33% aufweisen. Auch kann ein prozentualer Anteil von Chrom in der Legierung im Bereich von 18% bis 21% und/oder ein prozentualer Anteil von Kobalt in der Legierung im Bereich von 15% bis 21% liegen.

Durch die Bestandteile Nickel sowie zusätzlich Chrom und/oder Kobalt der Legierung des zeitstandfesten Werkstoffes der Vorspannhülse kann die Wärmebeständigkeit des Drucksensors verbessert werden. Grundsätzlich sind aber auch andere Anteile der genannten Legierungsbestandteile denkbar.

Die Summe der prozentualen Anteile aller Bestandteile der Legierung des zeitstandfesten Werkstoffes der Vorspannhülse beträgt immer 100%. Die Summe der prozentualen Anteile von Nickel, Chrom und Kobalt kann kleiner als 100% sein, wenn noch weitere Bestandteile in der Legierung vorhanden sind. Der prozentuale Anteil von Nickel kann so gewählt werden, dass die Summe der prozentualen Anteile aller Bestandteile der Legierung, einschliesslich Nickel, 100% beträgt.

In einer bevorzugten Ausführungsform ist die Legierung des zeitstandfesten Werkstoffes der Vorspannhülse ein Werkstoff mit der Werkstoffnummer 2.4632 gemäss Norm EN 10027-2:2015 oder die Legierung ist ein Werkstoff mit der UNS-Nummer N07090/W gemäss Norm ASTM E527-12. Die Legierung ist unter der Bezeichnung NIMONIC alloy 90 UNS N07090/W Nr. 2.4632 kommerziell verfügbar und überraschenderweise besonders geeignet für eine Vorspannhülse, die in einem Drucksensor bei hohen Temperaturen zum Einsatz kommt.

Piezoelektrische Elemente können scheibenförmig oder stabförmig sein. Der piezoelektrische Druckaufnehmer kann mehrere piezoelektrische Elemente aufweisen. Piezoelektrische Scheiben können gestapelt sein. Stabförmige piezoelektrische Elemente können nebeneinander in der Vorspannhülse angeordnet sein. Piezoelektrische Elemente können konzentrisch in der Vorspannhülse angeordnet sein.

Das piezoelektrische Element besteht aus piezoelektrischem Kristallmaterial wie Quarz (SiO2 Einkristall), Calcium-Gallo-Germanat (Ca3Ga2Ge4O14 oder CGG), Langasit (La3Ga5SiO14 oder LGS), Turmalin, Galliumorthophosphat, usw. Andere Materialien sind aber auch möglich, beispielsweise piezorestriktive Materialien.

In einer weiteren Ausführungsform weist der piezoelektrische Druckaufnehmer mindestens eine Elektrode zur Ableitung der unter Kraftwirkung erzeugten elektrischen Ladungen auf. Die Elektrode ist auf einer Aussenfläche des piezoelektrischen Elementes angeordnet. Mit Hilfe der Elektrode werden die elektrischen Ladungen abgegriffen und als Ausgangssignale abgeleitet. Falls im piezoelektrischen Druckaufnehmer mehrere piezoelektrische Elemente zum Einsatz kommen, können elektrische Ladungen gleichen Vorzeichens von verschiedenen piezoelektrischen Elementen über eine jeweilige Elektrode zusammengeführt werden.

In einer weiteren Ausführungsform weist der erfindungsgemässe Drucksensor eine mit dem piezoelektrischen Druckaufnehmer in Wirkverbindung stehende Membran zur Übertragung eines Druckverlaufes auf, wobei die Membran mit der Vorspannhülse mechanisch verbunden ist.

Eine mechanische Verbindung kann, wie schon zuvor erwähnt, eine stoffschlüssige, formschlüssige oder kraftschlüssige Verbindung sein. Eine stoffschlüssige Verbindung kann beispielsweise eine gelötete, geklebte oder eine geschweisste Verbindung sein. Die Membran kann insbesondere mit der Vorspannhülse verschweisst sein.

Die Membran kann ebenfalls mit dem Gehäuse mechanisch verbunden sein, insbesondere kann die Membran mit dem Gehäuse verschweisst sein.

Es hat sich gezeigt, dass eine stoffschlüssige Verbindung der Membran mit der Vorspannhülse, insbesondere eine Schweissverbindung von der Membran mit der Vorspannhülse, zu einer guten Übertragung der Kraft, die auf die Membran wirkt, auf den piezoelektrischen Druckaufnehmer führt.

Wenn die Membran mit dem Gehäuse mechanisch verbunden ist, insbesondere, wenn sie mit dem Gehäuse verschweisst ist, werden die Vorspannhülse und der piezoelektrische Druckaufnehmer vor dem Medium, dessen Druck gemessen werden soll, geschützt.

Ein weiterer Aspekt der vorliegenden Erfindung betrifft die Verwendung eines erfindungsgemässen Drucksensors zum Erfassen von Drücken bei Temperaturen von mehr als 300°C oder bis 1000°C.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: einen Längsschnitt durch eine Ausführungsform des erfindungsgemässen Drucksensors;
- Fig. 2: einen Längsschnitt durch eine Ausführungsform einer Vorspannhülse des erfindungsgemässen Drucksensors; und
- Fig. 3: eine Draufsicht auf eine Ausführungsform einer Vorspannhülse des erfindungsgemässen Drucksensors.

Grundsätzlich sind in den Figuren gleiche Teile mit gleichen Bezugszeichen versehen.

### Wege zur Ausführung der Erfindung

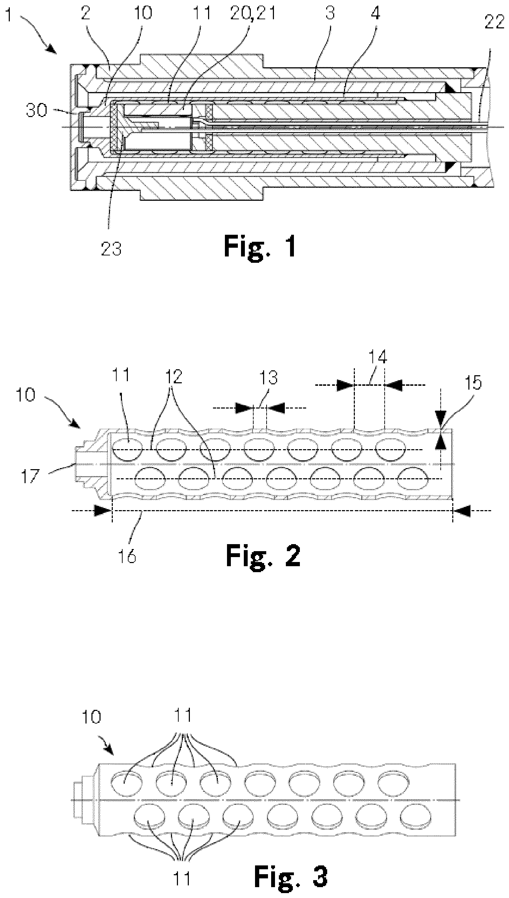

Fig. 1 zeigt einen Längsschnitt durch eine Ausführungsform eines erfindungsgemässen Drucksensors 1. Der Drucksensor 1 weist ein kreiszylinderförmiges Gehäuse 2 auf, in dessen Inneren eine hohlzylindrische Vorspannhülse 10 angeordnet ist. Die Vorspannhülse 10 verfügt über mindestens ein steifigkeitsminderndes Element 11 und ist in Fig. 2 und Fig. 3 separat dargestellt. Im Inneren der Vorspannhülse 10 ist ein piezoelektrischer Druckaufnehmer 20 angeordnet. Dabei berührt die Mantelfläche des piezoelektrischen Druckaufnehmers 20 den rohrförmigen Abschnitt der Vorspannhülse 10 nicht, d. h. der piezoelektrische Druckaufnehmer 20 ist vom rohrförmigen Abschnitt der Vorspannhülse 10 beabstandet. Der piezoelektrische Druckaufnehmer 20 wird während des Herstellungsprozesses in der Vorspannhülse 10 platziert, wobei die Vorspannhülse 10 dann unter Zugspannung mit dem Gehäuse 2 mittels Schweissen mechanisch verbunden wird, sodass der piezoelektrische Druckaufnehmer 20 im Betrieb des Drucksensors 1 unter Druckspannung steht. Der piezoelektrische Druckaufnehmer 20 besteht aus mehreren stabförmigen und konzentrisch angeordneten piezoelektrischen Elementen 21, welche unter der Wirkung einer Normalkraft elektrische Ladungen erzeugen können. Dabei gelangt die Normalkraft von einer endständig am Gehäuse 2 angeordneten Membran 30, welche dem zu erfassenden Druck ausgesetzt ist, über die Vorspannhülse 10 auf das piezoelektrische Element 21. Die Membran 30 ist mit dem Gehäuse 2 verschweisst und schützt die Vorspannhülse 10 sowie das piezoelektrische Element 21 vor dem Medium, dessen Druck erfasst werden soll. Die Membran 30 ist ebenfalls mit der Vorspannhülse 10 verschweisst. Die an den beiden Stirnseiten des piezoelektrischen Elementes 21 erzeugten elektrischen Ladungen haben jeweils ein verschiedenes Vorzeichen. Die elektrischen Ladungen eines erstens Vorzeichens können mit einer ersten Elektrode 22 abgegriffen werden. Die erste Elektrode 22 ist dabei in mechanischem und elektrischem Kontakt mit der Stirnseite des piezoelektrischen Elementes 21, wo sich die elektrischen Ladungen mit dem ersten Vorzeichen befinden. Die erste Elektrode 22 verfügt des Weiteren über einen leitungsähnlichen Abschnitt, mit dem die elektrischen Ladungen mit dem ersten Vorzeichen an das der Membran 30 abgewandte Ende des Gehäuses 2 abgeleitet werden können. Die elektrischen Ladungen eines zweiten Vorzeichens, welches von dem ersten Vorzeichen verschieden ist, können mit einer zweiten Elektrode 23 abgegriffen werden. Die zweite Elektrode 23 ist dabei in mechanischem und elektrischem Kontakt mit der Stirnseite des piezoelektrischen Elementes 21, wo sich die elektrischen Ladungen mit dem zweiten Vorzeichen befinden. Die zweite Elektrode 23 verfügt des Weiteren über einen leitungsähnlichen Abschnitt, mit dem die elektrischen Ladungen mit dem zweiten Vorzeichen an das der Membran 30 abgewandte Ende des Gehäuses 2 abgeleitet werden können. Die leitungsähnlichen Abschnitte der ersten Elektrode 22 und der zweiten Elektrode 23 befinden sich in der Nähe der Längsachse des erfindungsgemässen Drucksensors 1. Die leitungsähnlichen Abschnitte der ersten Elektrode 22 und der zweiten Elektrode 23 weisen eine elektrische Isolierung auf. Der erste Kanal 3 ist im Gehäuse 2 zwischen zwei Gehäusewänden angeordnet, wobei eine der zwei Gehäusewände eine Gehäuseaussenwand ist und eine andere der zwei Gehäusewände eine Gehäuseinnenwand ist, die an ihrer dem ersten Kanal 3 abgewandten Seite an den zweiten Kanal 4 angrenzt. Der zweite Kanal 4 wird zum Drucksensorinneren hin durch die Vorspannhülse 10 begrenzt.

Fig. 2 zeigt einen Längsschnitt durch eine Ausführungsform einer Vorspannhülse 10 des erfindungsgemässen Drucksensors 1. Die Vorspannhülse 10 weist eine Vielzahl von steifigkeitsmindernden Elementen 11 auf, die als kreisförmige Wandöffnungen mit einem Durchmesser von z. B. 1.9mm ausgeführt sind. Die kreisförmigen Wandöffnungen sind entlang von geraden Linien 12 angeordnet, so dass sie Reihen von Wandöffnungen bilden. Die geraden Linien 12 sind parallel zueinander und in eingebautem Zustand parallel zur Längsachse des Drucksensors angeordnet. Die Durchmesser 14 aller Wandöffnungen sind gleich. Die Abstände 13 von benachbarten Wandöffnungen in einer Reihe von Wandöffnungen sind ebenfalls gleich und betragen weitgehend 1mm. Benachbarte Reihen von Wandöffnungen sind versetzt angeordnet. Die Versetzung entspricht der halben Distanz zwischen zwei Mittelpunkten von zwei benachbarten Wandöffnungen einer Reihe von Wandöffnungen. Der Abstand zwischen zwei benachbarten geraden Linien 12 ist grösser als der Durchmesser 14 einer Wandöffnung. Der Abstand zwischen zwei benachbarten geraden Linien 12 ist kleiner als der doppelte Durchmesser 14 einer Wandöffnung. Der Abstand 13 zwischen zwei benachbarten Wandöffnungen in einer Reihe von Wandöffnungen ist weitgehend gleich dem Abstand zwischen zwei versetzt angeordneten Wandöffnungen von zwei benachbarten Reihen von Wandöffnungen. Die Wandstärke 15 im rohrförmigen Abschnitt der Vorspannhülse 10 beträgt weitgehend 0.25mm, d. h. die Wandstärke hat einen Bereich von 0.225mm bis 0.275mm. Die Länge 16 des rohrförmigen Abschnittes der Vorspannhülse 10 ist in etwas zehnmal grösser als die Länge des verjüngten Abschnittes der Vorspannhülse 10 am messseitigen Ende 17 der Vorspannhülse 10. Das messseitige Ende 17 der Vorspannhülse 10 ist offen.

Fig. 3 zeigt eine Draufsicht auf eine Ausführungsform einer Vorspannhülse 10 des erfindungsgemässen Drucksensors 1. Eine Gesamtlänge in längsaxialer Richtung der Vorspannhülse 10 beträgt mindestens das Fünffache, insbesondere mindestens das Zehnfache eines Gesamtdurchmessers in radialer Richtung der Vorspannhülse 10. Zu erkennen sind zwei Reihen von Wandöffnungen mit jeweils sieben Wandöffnungen. Darüber und darunter sind zwei weitere Reihen von Wandöffnungen mit jeweils sieben Wandöffnungen, dargestellt in Form von Einbuchtungen, erkennbar. Nicht erkennbar in Fig. 3 sind zwei weitere Reihen von Wandöffnungen mit jeweils sieben Wandöffnungen auf der (nicht dargestellten) Rückseite der Vorspannhülse 10. Insgesamt verfügt die Vorspannhülse 10 also über zweiundvierzig Wandöffnungen.

Versuche haben gezeigt, dass mit dem Drucksensor 1 bei Temperaturen bis 1000°C hohe Drücke über 100bar gemessen werden können und der Drucksensor 1 ohne weiteres bis zu einer Überlastgrenze von 150bar einsetzbar ist. Dies auch bei schnellen Druckverläufen, die Messfrequenzen mit einer zeitlichen Auflösung von bis zu 100kHz haben.

Der Drucksensor 1 ist nicht auf die vorstehend beschriebene Ausführungsform beschränkt und kann im Rahmen der Erfindung beliebig abgewandelt werden.

So kann der Drucksensor 1 oder die rohrförmige Vorspannhülse 10 prinzipiell auch eine nichtrunde Form, z.B. eine quaderförmige Form haben. Ebenfalls möglich ist es, den Drucksensor 1 ohne erste und/oder ohne zweite Kanäle zu realisieren. Auch kann beispielsweise eine anders geformte Membran 30, z.B. eine beidseitig flache oder gewölbte Membran 30, vorgesehen sein. Bei dem Drucksensor 1 kann zusätzlich eine Beschleunigungskompensation vorgesehen sein, damit der Drucksensor 1 auch in einem vibrierenden Objekt fehlerfrei arbeiten kann. Weitere Abwandlungen erschliessen sich dem Fachmann aufgrund seines Fachwissens.

Zusammenfassend ist festzustellen, dass der erfindungsgemässe Drucksensor 1 auch bei extremen Temperaturen bis 1000°C bei höchster Zuverlässigkeit hohe Drücke über 500bar erfassen kann und dies bei einer Lebensdauer des Drucksensors 1 von 10.000 bis zu 25.000 Betriebsstunden. Er ist damit bestens geeignet für den Betrieb auch unter sehr rauen Einsatzbedingungen.

**Bezugszeichenliste**

| Nr. | Merkmal | Anspruch | Figur |
|---|---|---|---|
| 1 | Drucksensor | 1 | 1 |
| 2 | Gehäuse | | 1 |
| 3 | erster Kanal | | 1 |
| 4 | zweiter Kanal | | 1 |
| 10 | Vorspannhülse | 1 | 1 |
| 11 | steifigkeitsminderndes Element | 9 | 1 |
| 12 | gerade Linie | 10 | 2 |
| 13 | Abstand zwischen zwei Wandöffnungen | | 2 |
| 14 | Durchmesser einer Wandöffnung | | 2 |
| 15 | Wandstärke | 7 | 2 |
| 16 | Länge des rohrförmigen Abschnittes | | 2 |
| 17 | messseitiges Ende | | 2 |
| 20 | piezoelektrischer Druckaufnehmer | 1 | 1 |
| 21 | piezoelektrisches Element | 12 | 1 |
| 22 | erste Elektrode | 13 | 1 |
| 23 | zweite Elektrode | 13 | 1 |
| 30 | Membran | 14 | 1 |

## Patentansprüche

1. Drucksensor (1) für den Betrieb bei hohen Temperaturen über 300°C oder bis 1000°C, mit einer Vorspannhülse (10); und mit einem piezoelektrischen Druckaufnehmer (20), welcher in der Vorspannhülse (10) angeordnet ist; und wobei die Vorspannhülse (10) den piezoelektrischen Druckaufnehmer (20) mechanisch vorspannt; wobei die Vorspannhülse (10) aus einem zeitstandfesten Werkstoff besteht; dass die Vorspannhülse (10) mindestens ein steifigkeitsminderndes Element (11) aufweist; **dadurch gekennzeichnet, dass** eine Wandstärke (15) der Vorspannhülse (10) das Drei- bis Zwanzigfache eines mittleren Korndurchmessers des Werkstoffes der Vorspannhülse (10) nach Standard E112 - 10 der ASTM beträgt und dass der Werkstoff der Vorspannhülse aus einer Legierung, welche Nickel als Hauptbestandteil enthält, besteht.

2. Drucksensor (1) nach Anspruch 1, **dadurch gekennzeichnet, dass** die Vorspannhülse (10) aus einem Werkstoff mit der Werkstoffnummer 2.4632 gemäss Norm EN 10027-2:2015 ist oder dass die Vorspannhülse (10) aus einem Werkstoff mit der UNS-Nummer N07090/W gemäss Norm ASTM E527-12 ist.

3. Drucksensor (1) nach einem der Ansprüche 1 oder 2, **dadurch gekennzeichnet, dass** eine Wandstärke (15) der Vorspannhülse (10) das Vier- bis Zehnfache der Korngrösse des Werkstoffes der Vorspannhülse (10) beträgt.

4. Drucksensor (1) nach Anspruch 3, **dadurch gekennzeichnet, dass** die Wandstärke (15) der Vorspannhülse (10) zeitstandfest ist, wenn sie mindestens das Fünffache der Korngrösse des Werkstoffes der Vorspannhülse beträgt.

5. Drucksensor (1) nach einem der Ansprüche 1 bis 4, **dadurch gekennzeichnet, dass** eine Gesamtlänge in einer längsaxialen Richtung der Vorspannhülse (10) mindestens das Fünffache, insbesondere mindestens das Zehnfache eines Gesamtdurchmessers in einer radialer Richtung der Vorspannhülse (10) beträgt.

6. Drucksensor (1) nach einem der Ansprüche 1 bis 5, **dadurch gekennzeichnet, dass** das steifigkeitsmindernde Element (11) eine längsaxiale Steifigkeit der Vorspannhülse (10) vermindert.

7. Drucksensor (1) nach Anspruch 6, **dadurch gekennzeichnet, dass** die Vorspannhülse (10) einen rohrförmigen Abschnitt aufweist; und dass das steifigkeitsmindernde Element (11) eine Wandöffnung im rohrförmigen Abschnitt ist.

8. Drucksensor (1) nach Anspruch 7, **dadurch gekennzeichnet, dass** die Wandöffnung kreisförmig oder oval oder mehreckig ist.

9. Drucksensor (1) nach einem der Ansprüche 7 oder 8, **dadurch gekennzeichnet, dass** ein prozentualer Anteil einer Oberfläche aller steifigkeitsmindernden Elemente (11) im rohrförmigen Abschnitt der Vorspannhülse (10) an einer Gesamtoberfläche des rohrförmigen Abschnittes der Vorspannhülse (10) einen Öffnungsgrad der Vorspannhülse (10) darstellt; und dass der Öffnungsgrad der Vorspannhülse (10) im Bereich von 30% bis 90%, insbesondere im Bereich von 40% bis 80%, im Speziellen im Bereich von 50% bis 70%, und im ganz Speziellen bei weitgehend 65% liegt.

10. Drucksensor (1) nach Anspruch 9, **dadurch gekennzeichnet, dass** die Wandstärke (15) der Vorspannhülse (10) mindestens das Fünffache der Korngrösse des Werkstoffes der Vorspannhülse beträgt; und dass ein prozentualer Anteil der Normalkraft, welche auf die Vorspannhülse (10) wirkt umgekehrt proportional zum Öffnungsgrad der Vorspannhülse (10) ist.

11. Drucksensor (1) nach einem der Ansprüche 7 bis 10, **dadurch gekennzeichnet, dass** die Wandöffnung einen grössten Durchmesser aufweist; und dass eine grösste Länge des rohrförmigen Abschnittes der Vorspannhülse (10) ein Vielfaches, insbesondere ein Drei- bis Zwanzigfaches des grössten Durchmessers der Wandöffnung beträgt.

12. Drucksensor (1) nach einem der Ansprüche 1 bis 11, **dadurch gekennzeichnet, dass** mehrere steifigkeitsmindernden Elemente (11) in Reihen entlang gerader Linien (12), die parallel zu einer Längsachse der Vorspannhülse 10 verlaufen, angeordnet sind; oder dass mehrere steifigkeitsmindernden Elemente (11) in Reihen entlang gerader Linien (12), die parallel zu einer Längsachse der Vorspannhülse 10 verlaufen, angeordnet sind und die versetzt zueinander angeordnet sind.

13. Drucksensor (1) nach einem der Ansprüche 1 bis 12, **dadurch gekennzeichnet, dass** der piezoelektrische Druckaufnehmer (20) mindestens ein piezoelektrisches Element (21) aufweist, welches unter Wirkung einer Normalkraft elektrische Ladungen erzeugt; und dass das piezoelektrische Element (21) mindestens eine Elektrode (22, 23) aufweist.

14. Drucksensor (1) nach einem der Ansprüche 1 bis 13, **dadurch gekennzeichnet, dass** er eine mit dem piezoelektrischen Druckaufnehmer (20) in Wirkverbindung stehende Membran (30) zur Übertragung eines Druckverlaufes aufweist, wobei die Membran (30) mit der Vorspannhülse (10) mechanisch verbunden ist.

15. Verwendung eines Drucksensors (1) nach einem der Ansprüche 1 bis 14 zum Erfassen von Drücken bei Temperaturen von mehr als 300°C, insbesondere bei Temperaturen von mehr als 500°C, und im Speziellen bei Temperaturen von mehr als 700°C.

## Claims

1. A pressure sensor (1) for operation at high temperatures of higher than 300°C or up to 1000°C, comprising a preloading sleeve (10); and comprising a piezoelectric pressure sensor (20) arranged in the preloading sleeve (10); and wherein the preloading sleeve (10) mechanically preloads the piezoelectric pressure sensor (20); wherein the preloading sleeve (10) is fabricated from a material with high creep rupture strength; said preloading sleeve (10) comprising at least one stiffness-weakening element (11), **characterized in that** a wall thickness (15) of the preloading sleeve (10) is three to twenty times a mean particle diameter of the material of the preloading sleeve (10) according to ASTM standard E112 - 10 and **in that** the material of the preloading sleeve consists of an alloy containing nickel as the main component.

2. The pressure sensor (1) according to claim 1, **characterized in that** the preloading sleeve (10) is made of a material having the material number 2.4632 according to EN Standard 10027-2:2015 or **in that** the preloading sleeve (10) is made of a material having the UNS number N07090/W is according to ASTM Standard E527-12.

3. The pressure sensor (1) according to any of the claims 1 or 2, **characterized in that** a wall thickness (15) of the preloading sleeve (10) is four to ten times the particle diameter of the material of the preloading sleeve (10).

4. The pressure sensor (1) according to claim 3, **characterized in that** the wall thickness (15) of the preloading sleeve (10) is creep-resistant if it is at least five times the particle diameter of the material of the preloading sleeve.

5. The pressure sensor (1) according to any of the claims 1 to 4, **characterized in that** an overall length in a direction along the longitudinal axis of the preloading sleeve (10) is at least five times, in particular at least ten times an overall diameter of the preloading sleeve (10) in a radial direction.

6. The pressure sensor (1) according to any of the claims 1 to 5, **characterized in that** the stiffness-weakening element (11) reduces a stiffness in the direction of the longitudinal axis of the preloading sleeve (10).

7. The pressure sensor (1) according to claim 6, **characterized in that** the preloading sleeve (10) comprises a tubular portion; and **in that** the stiffness-weakening element (11) is a wall opening in said tubular portion.

8. The pressure sensor (1) according to claim 7, **characterized in that** said wall opening is circular or oval or polygonal in shape.

9. The pressure sensor (1) according to any of the claims 7 or 8, **characterized in that** a percentage of a surface of all stiffness-weakening elements (11) within the tubular portion of the preloading sleeve (10) with respect to a total surface of the tubular portion of the preloading sleeve (10) represents a degree of opening of the preloading sleeve (10); and **in that** the degree of opening of the preloading sleeve (10) is in the range of 30% to 90%, particularly in the range of 40% to 80%, specifically in the range of 50% to 70%, and most particular is substantially 65%.

10. The pressure sensor (1) according to claim 9, **characterized in that** the wall thickness (15) of the preloading sleeve (10) is at least five times the particle diameter of the material of the preloading sleeve; and **in that** a percentage of the normal force acting onto the preloading sleeve (10) is inversely proportional to the degree of opening of the preloading sleeve (10).

11. The pressure sensor (1) according to any of the claims 7 to 10, **characterized in that** the wall opening has a largest diameter; and **in that** a greatest length of the tubular portion of the preloading sleeve (10) is a multiple of, in particular three to twenty times the largest diameter of the wall opening.

12. The pressure sensor (1) according to any of the claims 1 to 11, **characterized in that** a plurality of stiffness-weakening elements (11) are arranged in rows along straight lines (12) running parallel to a longitudinal axis of the preloading sleeve 10; or **in that** a plurality of stiffness-weakening elements (11) are arranged in rows along straight lines (12) running parallel to a longitudinal axis of the preloading sleeve 10 and are arranged offset from each other.

13. The pressure sensor (1) according to any of the claims 1 to 12, **characterized in that** the piezoelectric pressure transducer (20) comprises at least one piezoelectric element (21) that generates electrical charges under the action of a normal force; and **in that** said piezoelectric element (21) comprises at least one electrode (22, 23).

14. The pressure sensor (1) according to any of the claims 1 to 13, **characterized in that** it comprises a membrane (30) operatively connected to the piezoelectric pressure sensor (20) for transmitting a pressure profile wherein said membrane (30) is mechanically connected to the preloading sleeve (10).

15. Use of a pressure sensor (1) according to any of the claims 1 to 14 for detecting pressures at temperatures of higher than 300°C, in particular at temperatures of higher than 500°C, and specifically at temperatures of higher than 700°C.

## Revendications

1. Capteur de pression (1) pour un fonctionnement à des températures élevées supérieures à 300°C ou jusqu'à 1000°C, comprenant une douille de précharge (10); et comprenant un capteur de pression piézoélectrique (20) disposé dans la douille de précharge (10); et dans lequel ladite douille de précharge (10) précharge mécaniquement ledit capteur de pression piézoélectrique (20); dans lequel la douille de précharge (10) est fabriquée d'un matériau à haute résistance à la rupture par fluage; ladite douille de précharge (10) comprenant au moins un élément (11) affaiblissant la rigidité, **caractérisé en ce qu'**une épaisseur de paroi (15) de la douille de précharge (10) est de trois à vingt fois la granulométrie moyenne du matériau de la douille de précharge (10) selon la norme ASTM E112 - 10 et **en ce que** le matériau de la douille de précharge (10) est constitué d'un alliage contenant du nickel comme composant principal.

2. Capteur de pression (1) selon la revendication 1, **caractérisé en ce que** la douille de précharge (10) est réalisée d'un matériau portant le numéro de matériau 2.4632 selon la norme EN 10027-2:2015 ou **en ce que** la douille de précharge (10) est réalisée d'un matériau ayant le numéro UNS N07090/W selon la norme ASTM E527-12.

3. Capteur de pression (1) selon l'une quelconque des revendications 1 ou 2, **caractérisé en ce qu'**une épaisseur de paroi (15) de la douille de précharge (10) est de quatre à dix fois la granulométrie du matériau de la douille de précharge (10).

4. Capteur de pression (1) selon la revendication 3, **caractérisé en ce que** l'épaisseur de paroi (15) de la douille de précharge (10) est résistante au fluage si elle est au moins cinq fois la granulométrie du matériau de la douille de précharge.

5. Capteur de pression (1) selon l'une quelconque des revendications 1 à 4, **caractérisé en ce qu'**une longueur totale dans la direction de l'axe longitudinal de la douille de précharge (10) est au moins cinq fois, en particulier au moins dix fois un diamètre total de la douille de précharge (10) dans une direction radiale.

6. Capteur de pression (1) selon l'une quelconque des revendications 1 à 5, **caractérisé en ce que** l'élément affaiblissant la rigidité (11) réduit la rigidité en direction de l'axe longitudinal de la douille de précharge (10).

7. Capteur de pression (1) selon la revendication 6, **caractérisé en ce que** la douille de précharge (10) comprend une partie tubulaire; et **en ce que** l'élément affaiblissant la rigidité (11) est une ouverture de paroi dans ladite partie tubulaire.

8. Capteur de pression (1) selon la revendication 7, **caractérisé en ce que** ladite ouverture de paroi est de forme circulaire ou ovale ou polygonale.

9. Capteur de pression (1) selon l'une quelconque des revendications 7 ou 8, **caractérisé en ce qu'**un pourcentage de surface de tous les éléments affaiblissant la rigidité (11) dans la partie tubulaire de la douille de précharge (10) par rapport à la surface totale de la partie tubulaire de la douille de précharge (10) représente un degré d'ouverture de la douille de précharge (10); et **en ce que** ledit degré d'ouverture de la douille de précharge (10) est compris entre 30% et 90%, notamment compris entre 40% et 80%, spécifiquement compris entre 50% et 70%, et très précisément est sensiblement de 65%.

10. Capteur de pression (1) selon la revendication 9, **caractérisé en ce que** l'épaisseur de paroi (15) de la douille de précharge (10) est au moins cinq fois la granulométrie du matériau de la douille de précharge; et **en ce qu'**un pourcentage de la force normale agissant sur la douille de précharge (10) est inversement proportionnel au degré d'ouverture de la douille de précharge (10).

11. Capteur de pression (1) selon l'une quelconque des revendications 7 à 10, **caractérisé en ce que** l'ouverture de paroi a un diamètre le plus grand; et **en ce qu'**une longueur la plus grande de la partie tubulaire de la douille de précharge (10) est un multiple du diamètre le plus grand de l'ouverture de paroi, en particulier trois à vingt fois ledit diamètre.

12. Capteur de pression (1) selon l'une quelconque des revendications 1 à 11, **caractérisé en ce que** plusieurs éléments affaiblissant la rigidité (11) sont disposés en rangées le long de lignes droites (12) parallèles à un axe longitudinal de la douille de précharge 10; ou **en ce que** plusieurs éléments affaiblissant la rigidité (11) sont disposés en rangées le long de lignes droites (12) parallèles à un axe longitudinal de la douille de précharge 10 et sont disposés décalés les uns des autres.

13. Capteur de pression (1) selon l'une quelconque des revendications 1 à 12, **caractérisé en ce que** le transducteur de pression piézoélectrique (20) comprend au moins un élément piézoélectrique (21) qui génère des charges électriques sous l'action d'une force normale; et **en ce que** ledit élément piézoélectrique (21) comporte au moins une électrode (22, 23).

14. Capteur de pression (1) selon l'une quelconque des revendications 1 à 13, **caractérisé en ce qu'**il comprend une membrane (30) connectée fonctionnellement au capteur de pression piézoélectrique (20) pour transmettre un profil de pression dans lequel ladite membrane (30) est relié mécaniquement à la douille de précharge (10).

15. Utilisation d'un capteur de pression (1) selon l'une quelconque des revendications 1 à 14 pour détecter des pressions à des températures supérieures à 300°C, en particulier à des températures supérieures à 500°C, et spécifiquement à des températures supérieures à 700°C.
